**Europäisches Patentamt**

**European Patent Office**

**Office européen des brevets**

(19)

(11) Numéro de publication : **0 496 681 A1**

(12) # DEMANDE DE BREVET EUROPEEN

(21) Numéro de dépôt : **92420021.5**

(22) Date de dépôt : **20.01.92**

(51) Int. Cl.$^5$ : **H01J 37/32**

(30) Priorité : **22.01.91 FR 9100894**

(43) Date de publication de la demande :
**29.07.92 Bulletin 92/31**

(84) Etats contractants désignés :
**CH DE GB IT LI NL**

(71) Demandeur : **METAL PROCESS, Société à Responsabilité Limiteé:**
**20 Alleé du Château**
**F-77144 Montevrain (FR)**

(72) Inventeur : **Pelletier, Jacques**
**"Le Mûrier", Chemin du Fort**
**F-38400 Saint Martin d'Heres (FR)**

(74) Mandataire : **Thibault, Jean-Marc**
**Cabinet Beau de Loménie 51, Avenue Jean Jaurès B.P. 7073**
**F-69341 Lyon Cédex 07 (FR)**

(54) **Dispositif de répartition d'une énergie micro-onde pour l'excitation d'un plasma.**

(57) — Production de plasma.

— Le dispositif de répartition d'une énergie micro-onde pour l'excitation d'un plasma à l'intérieur d'une enceinte (1) comporte un ou des applicateurs (8) placés chacun à l'intérieur d'une zone inter-aimants (11),

caractérisé en ce que le ou les applicateurs (8) sont placés chacun à l'intérieur de la zone inter-aimants (11) en s'étendant en relation de distance de la surface de confinement (6) et de la paroi de l'enceinte, tout en étant positionné en dehors de la surface à champ magnétique (7) constant et d'intensité correspondant à la résonance cyclotronique électronique, de manière à assurer le confinement et la propagation de l'énergie micro-onde entre la paroi et l'applicateur, en dehors de la surface (7).

— Application aux traitements de surface.

FIG.1

La présente invention concerne le domaine technique général de la production de plasma à partir d'un milieu gazeux de toute nature, en vue d'applications très diverses, telles que les traitements de surface ou la production de faisceaux d'ions.

L'invention vise plus précisément le domaine de l'excitation d'un plasma par micro-ondes, en particulier à la résonance cyclotronique électronique.

Le brevet français n° **85-08 836 (2 583 250)** décrit une technique d'excitation de plasma à la résonance cyclotronique électronique. Cette résonance est obtenue pour un champ magnétique **B** et une fréquence d'excitation **f** liée par la relation :

$$B = \frac{2\pi mf}{e}$$

où **m** et **e** sont la masse et la charge de l'électron. A titre d'exemple, pour une fréquence de 2,45 GHz, un champ magnétique de 0,0875 Tesla est nécessaire pour obtenir la résonance.

La technique décrite dans cette demande de brevet française citée ci-dessus nécessite la mise en oeuvre d'aimants permanents créant chacun, près de leur pôle, au moins une surface à champ magnétique constant et d'intensité correspondant à la résonance cyclotronique électronique. L'énergie électromagnétique est amenée au niveau de la zone de résonance par l'intermédiaire d'antennes ou d'excitateurs de plasma, constitués chacun par un élément filaire métallique. Chaque excitateur est disposé au droit des aimants permanents qui sont montés sur la paroi de l'enceinte.

Le champ magnétique d'intensité égale à la valeur donnant la résonance et le champ électromagnétique sont tous les deux localisés et confinés essentiellement dans l'espace situé entre un excitateur et la partie de la paroi de l'enceinte placée en vis-à-vis d'un aimant. En présence d'un milieu gazeux présentant une pression réduite, les électrons sont accélérés dans la zone de résonance et s'enroulent le long des lignes de champ magnétique qui définissent une surface de confinement du plasma. Ces lignes de champ en forme de feston relient le pôle d'un aimant à son pôle opposé ou au pôle opposé d'un aimant consécutif. Le long de son trajet, l'électron dissocie et ionise les molécules et les atomes avec lesquels il entre en collision. Le plasma ainsi formé dans les festons de champ magnétique diffuse ensuite, à partir de ces lignes de champ pour former un plasma froid pratiquement exempt des électrons énergétiques qui restent piégés dans les festons.

En l'absence de gaz dans l'enceinte, la propagation de l'énergie micro-onde s'effectue sans perte le long de l'excitateur constitué par l'applicateur filaire positionné à proximité des pôles des aimants permanents. En présence d'un gaz à ioniser, le plasma s'amorce à la résonance cyclotronique électronique et la propagation des micro-ondes ne peut donc s'effectuer qu'avec des pertes et la puissance micro-onde disponible décroît progressivement le long de l'excitateur à partir de la source micro-onde. De plus, il apparaît que la densité de plasma diminue, dans la mesure où cette densité décroît en même temps que la puissance micro-onde.

Un autre inconvénient de la technique décrite ci-dessus tient au fait que l'énergie micro-onde peut être appliquée uniquement à l'une des extrémités de l'excitateur filaire. En conséquence, l'énergie micro-onde ne peut être appliquée sur une antenne bouclée, telle qu'une antenne circulaire.

La présente invention vise donc à remédier aux inconvénients énoncés ci-dessus en proposant un dispositif adapté pour assurer la propagation et la répartition de l'énergie micro-onde avec un minimum de pertes, sur toute la longueur de la zone de résonance cyclotronique électronique, de manière à obtenir une puissance micro-onde maximale autorisant une densité de plasma pratiquement constante.

Pour atteindre cet objectif, le dispositif de répartition d'une énergie micro-onde pour l'excitation d'un plasma à l'intérieur d'une enceinte comporte, d'une part, au moins un applicateur d'une énergie dans le domaine des micro-ondes et, d'autre part, au moins un couple d'aimants permanents créant chacun une surface à champ magnétique constant et d'intensité correspondant à la résonance cyclotronique électronique, ces aimants de polarités opposées étant espacés pour définir une surface de confinement du plasma qui délimite, avec une partie de la paroi de l'enceinte, une zone inter-aimants.

Selon l'invention, le ou les applicateurs sont placés chacun à l'intérieur de la zone inter-aimants en s'étendant en relation de distance de la surface de confinement et de la paroi de l'enceinte, tout en étant positionnés en dehors de la surface à champ magnétique constant et d'intensité correspondant à la' résonance cyclotronique électronique, de manière à assurer le confinement et la propagation de l'énergie micro-onde entre la paroi et l'applicateur, en dehors de la surface.

L'objet de l'invention vise donc à assurer la propagation de l'énergie micro-onde dans une zone localisée où les conditions d'excitation du plasma, en particulier à la résonance cyclotronique électronique, ne sont pas réunies. La propagation de l'énergie micro-onde dans la zone inter-aimants située hors de la résonance cyclotronique électronique peut s'effectuer sans pertes significatives.

Diverses autres caractéristiques ressortent de la description faite ci-dessous en référence aux dessins annexés qui montrent, à titre d'exemples non limitatifs, des formes de réalisation de l'objet de l'invention.

La **fig. 1** montre de façon schématique une machine de production de plasma mettant en oeuvre un dispositif de répartition d'une énergie micro-onde conforme à l'invention.

La **fig. 2** illustre un dispositif élémentaire de répartition conforme à l'invention.

La **fig. 3** est une vue schématique en coupe d'une variante de réalisation d'un dispositif conforme à l'invention.

La **fig. 4** représente, en perspective, un exemple de réalisation d'un dispositif conforme à la **fig. 3**.

La **fig. 5** est une vue en coupe transversale prise sensiblement selon les lignes V-V de la **fig. 4**.

La **fig. 6** illustre une autre variante de réalisation d'un dispositif conforme à l'invention.

La **fig. 7** est une vue en demi-perspective d'une autre variante de réalisation d'un dispositif selon l'invention.

La **fig .1** illustre, à titre d'exemple, une machine de production d'un plasma à partir de milieux gazeux de toute nature, en vue d'applications très diverses, tels que les traitements de surfaces ou la production de faisceaux d'ions. La machine comporte une enceinte étanche **1** amagnétique, équipée d'un dispositif **2** d'introduction de gaz et d'un dispositif **3** de pompage de gaz permettant de maintenir la pression du gaz à ioniser à une valeur souhaitée qui peut être, par exemple, de l'ordre de $10^{-2}$ à quelques Pascals. La machine comporte également un dispositif conforme à l'invention, de répartition d'une énergie micro-onde pour l'excitation de ce plasma, à la résonance cyclotronique électronique. A cet effet, le dispositif comprend une structure magnétique multipolaire constituée par au moins deux, et par exemple, une série d'aimants permanents **4** assurant le confinement du plasma dans une zone centrale **5**. Le plasma permet, dans la zone d'utilisation **5**, un traitement de surface d'un échantillon **A**, placé sur un porte échantillon **B** et polarisé par rapport au potentiel plasma à l'aide d'un générateur **C**.

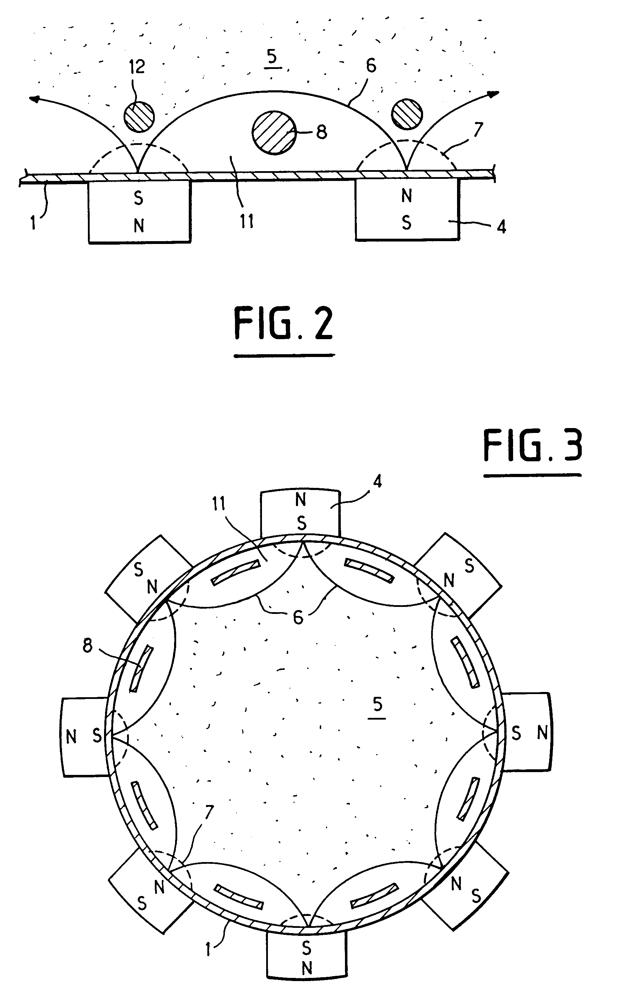

Les aimants permanents **4**, qui s'étendent sensiblement parallèlement entre eux, présentent successivement au plasma des polarités alternées, de façon à constituer une surface magnétique **6** se présentant sous la forme de festons de lignes de champ magnétique. Il est à noter que les aimants **4** sont positionnés de manière que les lignes de champ magnétique en forme de festons relient le pôle d'un aimant à son pôle opposé ou au pôle opposé d'un aimant consécutif. Le plasma est ainsi confiné dans la zone **5** à l'intérieur des festons de ligne de champ magnétique **6**. La structure magnétique multipolaire est réalisée de manière à obtenir localement un champ magnétique d'intensité suffisante pour assurer la résonance cyclotronique électronique. Tel que cela ressort plus précisément de la **fig. 2**, chaque aimant **4** est apte à créer une surface **7** à champ magnétique constant et d'intensité correspondant à la résonance cyclotronique électronique. Cette surface **7** enveloppe les pôles des aimants, comme représenté en pointillé sur la **fig. 2**. Par exemple, pour une fréquence d'excitation de 2,45 GHz, le champ magnétique doit être de 0,0875 Tesla et pour une fréquence d'excitation de 5,8 GHz, l'intensité du champ magnétique doit être de 0,207 Tesla.

Le dispositif de répartition conforme à l'invention comprend aussi au moins un, et dans l'exemple illustré, une série d'applicateurs **8** d'une énergie dans le domaine des micro-ondes, positionnés dans une région localisée donnée. Ces applicateurs **8** sont reliés par tous moyens convenables à un générateur **9** d'une énergie micro-onde par l'intermédiaire d'un adaptateur d'impédance **10**. Conformément à l'invention, pour chaque couple d'aimants **4**, l'applicateur **8** associé est positionné à l'intérieur d'une zone **11** s'établissant entre deux aimants successifs et délimités par la partie de la paroi de l'enceinte **1** placée en regard et par la surface de confinement **6** du plasma. La zone inter-aimants **11** s'étend donc en dehors de la zone **5** de confinement du plasma, entre la surface de confinement **6** et la paroi de l'enceinte **1**. De préférence, les aimants **4** sont placés à l'extérieur de la paroi de l'enceinte, comme illustré sur les dessins.

Selon l'invention, l'applicateur **8** est placé en relation de distance de la surface de confinement **6** et de la paroi de l'enceinte **1**, tout en étant positionné avantageusement en dehors de la surface **7** à champ magnétique constant et d'intensité correspondant à la résonance cyclotronique électronique.

Une telle disposition de l'applicateur **8** permet le confinement et la propagation de l'énergie micro-onde avec le minimum de pertes entre l'applicateur **8** et la partie correspondante de la paroi de l'enceinte **1**. En effet, le plasma dense créé dans les surfaces de confinement **6**, se comporte comme un conducteur et l'énergie micro-onde reste confinée dans la zone **11** interne aux festons. L'excitation du plasma s'effectue à partir de la surface **7** à champ magnétique constant et d'intensité correspondant à la résonance cyclotronique électronique.

Il doit être considéré que plus le champ magnétique est élevé et plus l'aire des surfaces **7** à intensité de champ magnétique constante égale à la résonance est importante, plus le confinement magnétique est amélioré et meilleur est le couplage de l'énergie micro-onde. Aussi, il doit être considéré que l'objet de l'invention peut être mis en oeuvre avec des aimants produisant un champ magnétique dont l'intensité peut être supérieure, mais en tout cas au moins égale à celle correspondant à la 'résonance cyclotronique électronique.

Avantageusement, l'applicateur **8** est situé à une distance donnée de la partie de la paroi **1** en regard (de l'ordre du centimètre), de façon à ne pas produire des arcs de plasma entre la paroi de l'enceinte et l'applicateur **8** aux pressions de travail usuelles des plasmas excités à la résonance cyclotronique électronique (de l'ordre de $10^{-2}$ à quelques Pascals suivant la nature du gaz). De plus, l'applicateur **8** est placé dans la zone **11**, de manière à ne pas couper la surface de confinement **6**, siège de l'excitation de plasma.

Dans une forme de réalisation de l'objet de l'invention, des antennes ou applicateurs filaires **12** sont positionnés selon tout arrangement possible par rapport aux aimants **4** pour être situés au moins à proximité de la surface **7** à champ magnétique constant et d'intensité correspondant à la résonance cyclotronique électronique (**fig. 2**). De préférence, ces antennes **12** qui ne sont pas reliées à une source d'énergie micro-onde, sont placées chacune à l'intersection du plan médian d'un aimant et de la surface **7**. La mise en oeuvre des antennes **12** permet de coupler latéralement sur celles-ci l'énergie micro-onde propagée par les applicateurs **8**. Ainsi, il apparaît possible de découpler, d'une part, la fonction de propagation de l'énergie micro-onde assurée par les applicateurs **8** et, d'autre part, la fonction d'excitation du plasma à la résonance cyclotronique électronique assurée par les antennes **12**. Des densités de plasma uniformes peuvent, de la sorte, aussi être produites le long des antennes **12**.

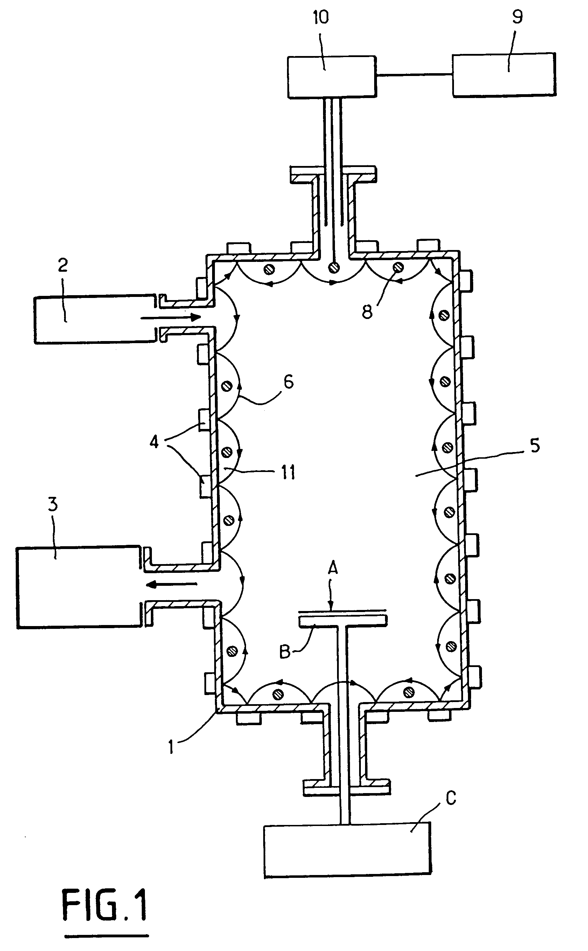

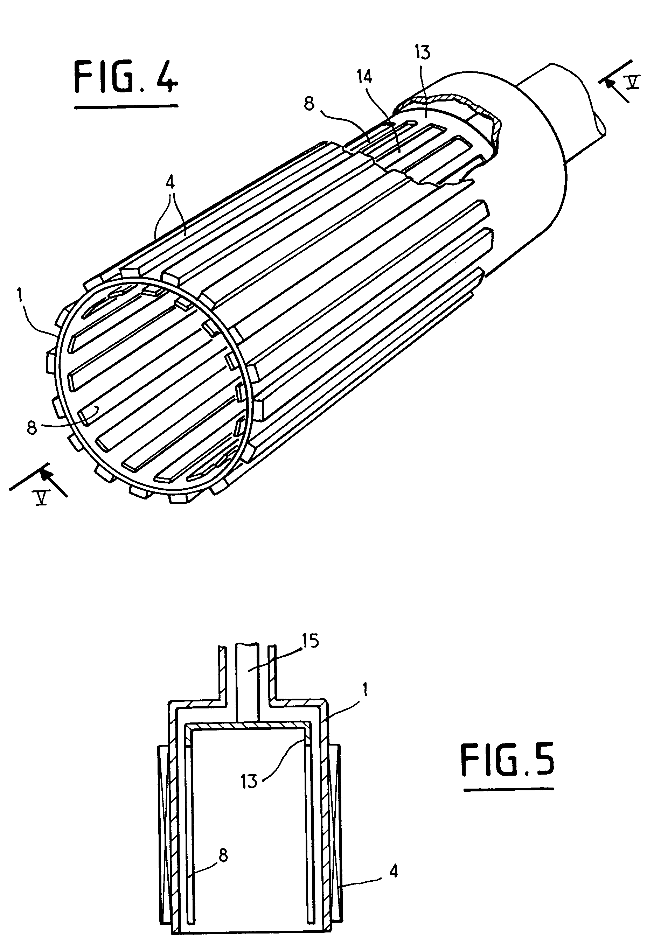

Tel que cela apparaît plus précisément aux **fig. 3** à **5**, les applicateurs **8** s'étendent parallèlement au moins, et de préférence, sur toute la partie de la longueur des aimants **4** et de la paroi de l'enceinte **1**. Les applicateurs **8** peuvent être refroidis par l'intermédiaire de la circulation d'un fluide et être revêtus de couches métalliques et/ou diélectriques appropriées à l'application plasma envisagée. Les différents applicateurs **8** peuvent être indépendants les uns des autres et se présenter sous des formes diverses, telles qu'un élément filaire (**Fig. 1** et **2**). Ainsi, il peut être prévu, comme illustré aux **fig. 3** à **5**, de réaliser chaque applicateur **8** sous la forme d'une barre faisant partie d'un tube **13** concentrique à la paroi de l'enceinte **1**. Cette enceinte **1** présente la forme d'un cylindre portant extérieurement les aimants **4** espacés angulairement entre eux, de manière sensiblement régulière. Le tube **13** est pourvu de lumières longitudinales **14** délimitant les barres applicateurs **8** positionnées pour s'étendre chacune dans une zone inter-aimants **11**, comme précisé ci-dessus. Le tube **13** peut être alimenté en énergie micro-onde à l'aide d'une structure coaxiale **15**, tel que cela ressort clairement de la **fig. 5**.

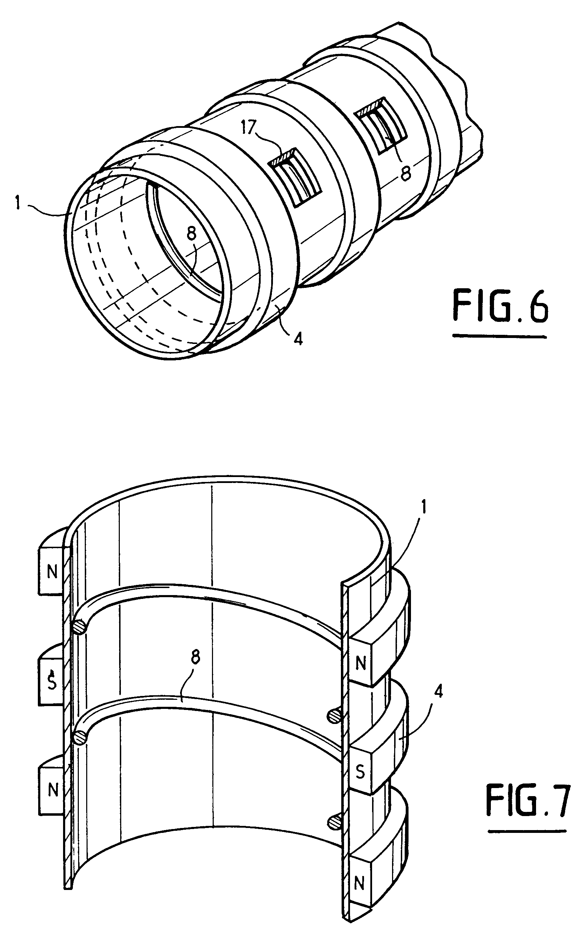

La **fig. 6** illustre une autre forme de réalisation du dispositif de répartition conforme à l'invention d'une énergie micro-onde comportant des applicateurs **8** constitués chacun sous la forme d'une boucle s'étendant parallèlement aux aimants **4** qui sont formés chacun sous la forme d'un anneau, adapté radialement sur la paroi de l'enceinte **1**. Comme explicité ci-dessus, les aimants offrent, en direction de la zone de confinement, une face de polarité successivement différente. Chaque applicateur **8** formant une boucle est positionné à l'intérieur de la zone inter-aimants **11** définie ci-dessus. Chaque applicateur **8** est alimenté en énergie micro-onde par tous moyens adaptés à travers, par exemple, des ouvertures **17** ménagées dans la paroi **1**.

La **fig. 7** illustre une autre forme de réalisation du dispositif de répartition selon l'invention, dans laquelle les aimants **4** et les applicateurs **8** sont réalisés sous la forme d'hélices intercalées axialement, en respectant les positions définies selon l'objet de l'invention. Bien entendu, il doit être considéré que les formes de réalisation décrites ci-dessus, concernant les applicateurs **8** et les aimants **4**, ne sont données qu'à titre d'exemple non limitatif.

Le dispositif de répartition d'une énergie micro-onde, selon l'invention, permet d'obtenir une excitation uniforme du plasma sur de grandes longueurs. De plus, un tel dispositif assure un meilleur couplage des micro-ondes au plasma et autorise l'injection de l'énergie micro-onde en tous points de l'applicateur. De plus, une telle disposition permet d'exciter des structures magnétiques fermées ou non se présentant sous la forme d'anneaux, de sphères ou de tores, par exemple.

L'invention n'est pas limitée aux exemples décrits et représentés, car diverses modifications peuvent y être apportées sans sortir de son cadre.

## Revendications

**1** - Dispositif de répartition d'une énergie micro-onde pour l'excitation d'un plasma à l'intérieur d'une enceinte (**1**) comportant, d'une part, au moins un applicateur (**8**) d'une énergie dans le domaine des micro-ondes et, d'autre part, au moins un couple d'aimants (**4**) permanents créant chacun une surface (**7**) à champ magnétique constant et d'intensité correspondant à la résonance cyclotronique électronique, ces aimants de polarités opposées étant espacés pour définir une surface (**6**) de confinement du plasma qui délimite, avec une partie de la paroi de l'enceinte, une zone inter-aimants (**11**),
caractérisé en ce que le ou les applicateurs (**8**) sont placés chacun à l'intérieur de la zone inter-aimants (**11**) en s'étendant en relation de distance de la surface de confinement (**6**) et de la paroi de l'enceinte, tout en étant positionné en dehors de la surface à champ magnétique (**7**) constant et d'intensité correspondant à la résonance cyclotronique électronique, de manière à assurer le confinement et la propagation de l'énergie micro-onde entre la paroi et l'applicateur, en dehors de la surface (**7**).

**2** - Dispositif selon la revendication 1, caractérisé en ce que le ou les applicateurs (**8**) s'étendent parallèlement au moins sur une partie de la longueur des aimants et de la paroi de l'enceinte.

**3** - Dispositif selon la revendication 1 ou 2, caractérisé en ce que chaque applicateur (**8**) s'étend à une distance donnée de la paroi pour éviter la production d'arcs de plasma entre l'applicateur et la paroi.

**4** - Dispositif selon l'une des revendications 1 à 3, caractérisé en ce que le ou les applicateurs (**8**) sont constitués chacun par une barre faisant partie d'un tube (**13**) concentrique à l'enceinte, chaque barre s'étendant dans la zone inter-aimants (**11**), selon une direction sensiblement parallèle aux aimants qui offrent, en direction de la zone de confinement, une face de polarité successivement différente.

**5** - Dispositif selon l'une des revendications 1 à 3, caractérisé en ce que l'applicateur (**8**) forme une boucle s'étendant, dans la zone inter-aimants (**11**), parallèlement aux aimants constituant chacun un anneau.

**6** - Dispositif selon l'une des revendications 1 à 3, caractérisé en ce que chaque applicateur (**8**) s'étend sous la forme d'une hélice, dans la zone inter-aimants (**11**) délimitée par deux aimants consécutifs réalisés en hélice.

**7** - Dispositif selon l'une des revendications 1 à 3, caractérisé en ce que le ou les applicateurs (**8**) sont reliés à une source micro-onde en un point quelconque de l'applicateur.

**8** - Dispositif selon l'une des revendications 1 à 7, caractérisé en ce que chaque applicateur (**8**) est positionné à l'intérieur de la zone inter-aimants (**11**) délimitée par deux aimants (**4**), placés à l'extérieur de l'enceinte (**1**).

**9** - Dispositif selon l'une des revendications 1 à 8, caractérisé en ce qu'il comporte des antennes (**12**) positionnées chacune en relation de proximité de la surface (**7**) à champ magnétique constant et d'intensité correspondant à la résonance cyclotronique électronique.

**10** - Machine de production d'un plasma du type comprenant une enceinte étanche (**1**) raccordée à un dispositif (**3**) de pompage et à un dispositif (**2**) d'apport d'un milieu gazeux pour maintenir une pression déterminée dans l'enceinte, caractérisée en ce qu'elle comporte un dispositif de répartition d'une énergie micro-onde, conforme à l'une des revendications 1 à 9.

FIG.1

FIG. 2

FIG. 3

FIG. 4

FIG.5

FIG.6

FIG.7

**Office européen des brevets**

## RAPPORT DE RECHERCHE EUROPEENNE

Numero de la demande

EP 92 42 0021

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.5) |
|---|---|---|---|
| D,Y | EP-A-0 209 469 (ETAT FRANCAIS) | 1,2,5,7, 8,10 | H01J37/32 |
| D,A | * abrégé * <br> * page 6, ligne 15 - page 7, ligne 5 * <br> * page 8, ligne 1 - ligne 5 * <br> --- | 4 | |
| Y | US-A-4 716 491 (OHNO ET AL.) <br><br> * colonne 1, ligne 6 - ligne 11 * <br> * colonne 2, ligne 51 - colonne 3, ligne 24 * <br> * colonne 4, ligne 15 - ligne 54; figures 1-5 * <br> --- | 1,2,5,7, 8,10 | |
| A | PATENT ABSTRACTS OF JAPAN <br> vol. 14, no. 368 (E-962)9 Août 1990 <br> & JP-A-2 132 737 ( NISSIN ) 22 Mai 1990 <br> * abrégé * <br><br> ----- | 1,2,7,9 | |

**DOMAINES TECHNIQUES RECHERCHES (Int. Cl.5)**

H01J

Le présent rapport a été établi pour toutes les revendications

| Lieu de la recherche | Date d'achèvement de la recherche | Examinateur |
|---|---|---|
| LA HAYE | 21 AVRIL 1992 | GREISER N. |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

& : membre de la même famille, document correspondant

EPO FORM 1503 03.82 (P0402)